# EUROPEAN PATENT SPECIFICATION

(11) **EP 0 478 871 B1**
(45) Date of publication and mention of the grant of the patent: **28.04.2004**
(21) Application number: 90830428.0
(22) Date of filing: 01.10.1990
(51) Int. Cl.: H01L 21/768

(54) **Formation of contact plugs by blanket CVD deposition and etchback**
Herstellung von Kontaktanschlüssen bei der alles überdeckenden CVD-Abscheidung und Rückätzen
Formation des prises de contact par dépôt-CVD sur toute une surface et décapage

(43) Date of publication of application: 08.04.1992
(73) Proprietor: STMicroelectronics S.r.l., 20041 Agrate Brianza (Milano) (IT)
(72) Inventor: Baldi, Livio, I-20041 Agrate Brianza (IT); Erratico, Pietro, I-20133 Milano (IT)
(74) Representative: Pellegri, Alberto

(56) References cited:
- EP-A- 0 245 627
- DE-A- 3 636 547
- PROCS. 1987 IEEE MULTILEVEL INTERCONNECTION CONFERENCE 15-16/6/1987 pages 193 - 199; J.J. LEE ET.AL: "A STUDY OF TUNGSTEN ETCHBACK FOR CONTACT AND VIA FILL APPLICATIONS"
- IEEE TRANSACTIONS ON SEMICONDUCTOR MANUFACTURING. vol. 3, no. 3, August 1990, NEW YORK US pages 142 - 144; P.E. RILEY ET.AL: "DEVELPOMENT OF A MAGNETRON ENHANCED PLASMA PROCESS FOR TUNGSTEN ETCHBACK WITH RESPONSE-SURFACE METHOLOGY"

## Description

The present invention relates to the fabrication of high and very high scale of integration semiconductor devices and, more in particular, to an improved process for forming contacts and interconnection vias having micrometric and submicrometric dimensions.

In LSI and VLSI fabrication processes, characterized by a limit linewidth of about 1 µm or less, the formation of contacts with the semiconducting substrate and of the interconnection vias between different level metallizations represents a very critical aspect because of the extremely small sizes which necessarily must assume such features.

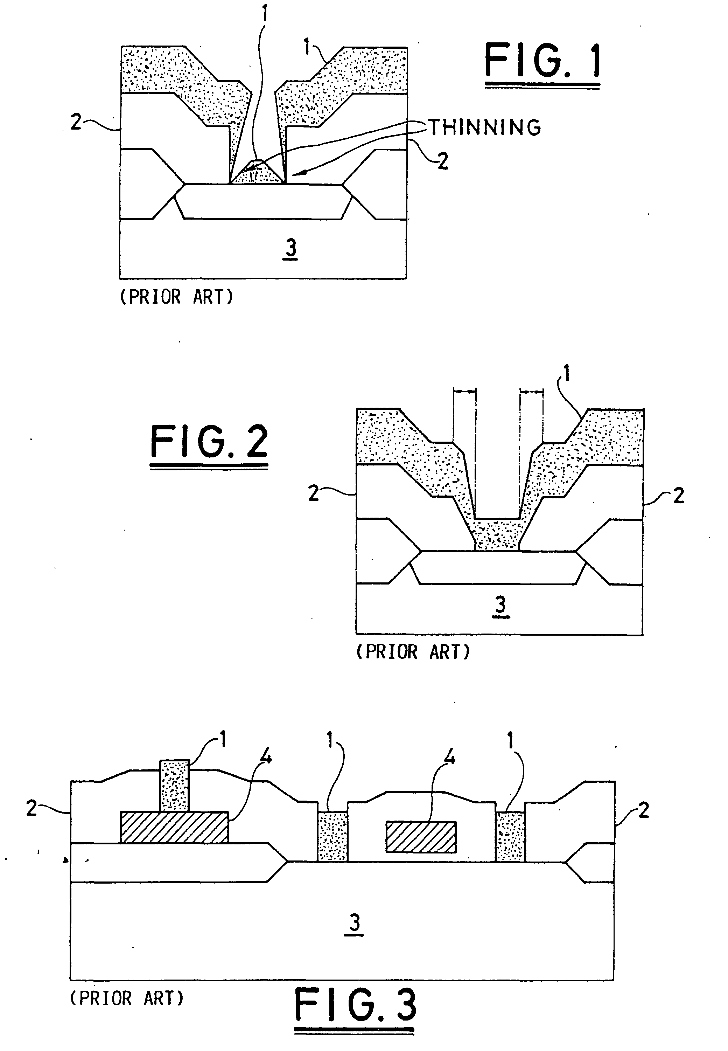

Under such a condition of extremely reduced size of the relative "holes" which must be formed through an isolation dielectric layer, when, as schematically shown in Fig. 1, the method used for depositing the metal 1 possesses a certain directionality (anisotropy), as in the case of the traditional sputter deposition of aluminum or of an aluminum alloy, step coverage (i.e. the coverage of the straight side walls of the contact holes) becomes unsatisfactory and through a self-enhancing shadow effect, the metal deposit within the contact holes may show unacceptable thinnings which may lead in practice to a discontinuity of the electrical path or in any case to an eccessive current concentration which may promote electromigration of the metal. On the other hand it is impossible to proportionally reduce also the thickness of the isolating dielectric layer 2, i.e. the depth of the contact hole, because such a reduction of thickness would increase the parasitic capacitances between the metallization layer 1 and the semiconducting substrate 3, thus impairing the speed performance of the circuits.

A commonly adopted solution to date consists in forming tapered contacts, i.e. with the side walls of the relative holes diverging toward the opening in order to avoid forming vertical steps. These tapered holes may be more easily covered by the metal, as schematically shown in Fig. 2. Controlled erosion of the masking resist, modification of the anisotropy conditions during the etching of the dielectric, thermal reflow of the dielectric material by means of high a temperature treatment are all techniques which have been proposed for tapering the contact profile. All these techniques, beside being intrinsically difficult to control, produce contacts having overall dimensions which are often larger than the lithographic limit of the process, with an evident non-negligeable sacrifice in terms of packing density.

A possible solution of the problem is based on the use of a metal which may be deposited by chemical vapor deposition (CVD), a technique which is easily controlled and which is characterized by an excellent isotropy and produces an excellent step coverage and thus an easy filling also of cavities having a high depth-to-width ratio. Suitable metallic materials which may deposited in this way are, for example, tungsten, titanium, their alloys and titanium nitride. In order to obviate to the relatively high resistivity of these materials in respect to that of aluminum, it has been proposed to fill the holes formed through the dielectric layer with one or more of these CVD deposable metallic materials, thus forming a first portion of the plugs with one or more of these materials and to employ a different, highly conductive, metallic material, such as aluminum, to form subsequently a conducting layer which may be defined by masking and etching in order to create the desired electric connection tracks of the so formed contacts. According to a first known technique, disclosed in the article "SELECTIVE CVD OF TUNGSTEN AND ITS APPLICATIONS TO MOS VLSI" by Takahiko Moriya e Hitoshi Itoh VLSI Research Center, Toshiba Corporation, presented at the 1985 Workshop of Material Research Society, tungsten or an equivalent material is deposited under special conditions capable of determining a selective deposition of the metal only on exposed surfaces of the semiconducting substrate and/or of existing metal structures and metallization layers (e.g. on the exposed surface of a doped polycrystalline silicon gate structure or on a first level aluminum metallization layer) and not on surfaces of essentially dielectric layers, as schematically shown in Fig. 3. This technique is extremely sensitive to contaminations of the surfaces which may reduce and vanify deposition selectivity through undesired nucleations of the metallic material also on the surface of the isolation dielectric layer with a consequent growth also in those sites of the metallic deposit. Moreover, as indicated in Fig. 3, the contact areas with the semiconducting substrate 3 and with existing "polysilicon" lines 4, are commonly at different levels and this difference of the initial level of nucleation of the metallic material deposit is reproduced in practice on the final levels reached by the respective peaks of the so-formed plugs at the end of such a selective chemical vapor deposition process of the metallic material. This difference among the levels of the peaks of the plugs in respect to the respectively adjacent surface of the isolation dielectric layer 2 may be hardly eliminated and creates remarkable problems to the subsequent formation of the interconnecting metal tracks. An analogous problem is faced when, with the same technology, contact plugs are grown on a first metallization level, for filling the contact holes between said first level and a second metallization level (commonly referred to as vias).

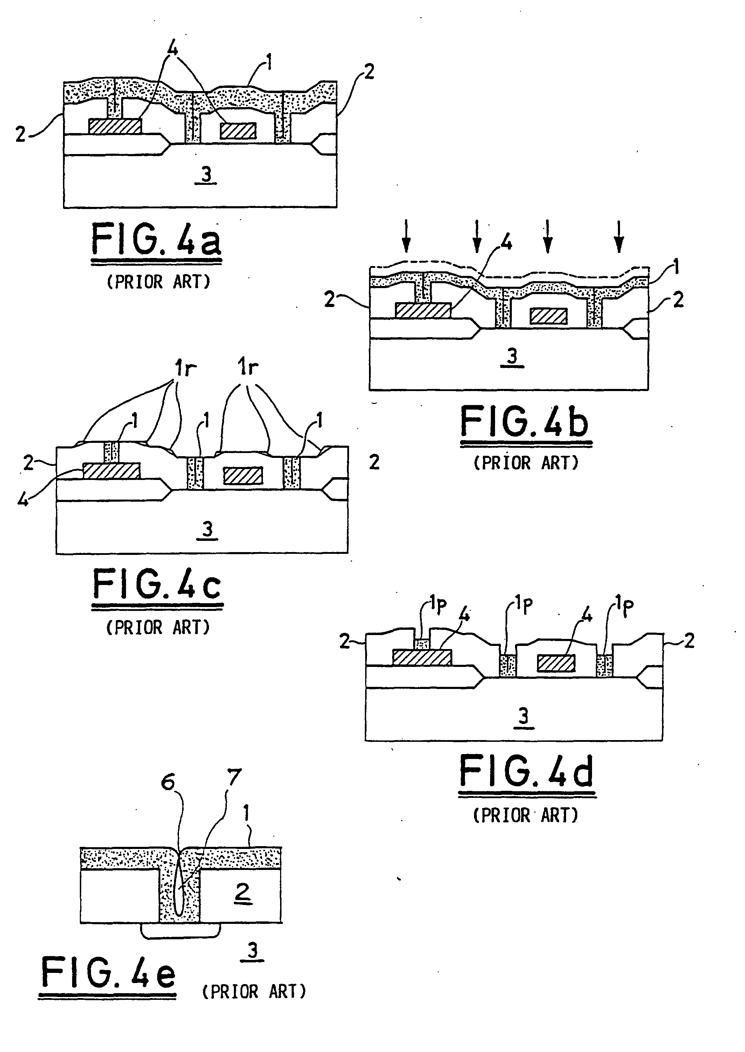

According to another known technique, the CVD deposable metallic material 1 is deposited under nonselective conditions (blanket deposition) in order to completely fill the holes formed through the thickness of the isolation dielectric layer 2, as shown in Fig. 4a. According to this blanket deposition technique, it is empirically sufficient for the thickness of the deposited layer to be greater than half the width of the hole for substantially ensuring a complete filling of the cavity, the depth of the latter being of, a secondary importance. Subsequently an anisotropic etching (etchback) is conducted, as shown in Fig. 4b, until the chemically deposited metallic material is left only inside the holes (contacts and interconnection vias). An exhausting description of this second known technique is contained in the article "A STUDY OF TUNGSTEN ETCHBACK FOR CONTACT AND VIA FILL APPLICATIONS" by Jen-Jian Lee e Dennis C. Hartman, presented at the IEEE VLSI Multilevel Interconnection Conference (VMIC) of 1987. There is though the drawback that being the surface of the dielectric layer 2 not perfectly flat, residues of the metallic material 1 with which the contacts and interconnection vias holes have been filled inevitably remain also along steps and generally along discontinuities from planarity of the surface of the dielectric layer, as pointed out in Fig. 4c. A complete removal of those metal residues on the surface of the isolation dielectric layer, which could otherwise constitute as many short-circuiting paths, requires an overetching treatment of the metallic material 1 at the end of the etchback process for a 30 to 50% of the etch time of the preceding etchback step, however such an overetching undesirably lowers on the other hand the level of the peaks of the formed plugs, thus worsening the planarity conditions, as shown in Fig. 4d. Another problem is represented by the fact that the filling of the contact hole by nonselective CVD deposited metal starts from the walls of the contact hole toward the center thereof. In case of contacts having a substantially vertical profile, or worse with a negative profile (i.e. with a certain undercut), this mechanism of growth may lead to an occlusion 6 near the top of the contact hole with the consequence of leaving a cavity 7 inside the contact plug, as depicted in Fig. 4e. During the following overetching step the bottom of the cavity may become exposed to the etch and this may lead to an accidental etching of the underlying junction region.

The document De-A-3636547 describes a technique for filling contact holes by growing within the holes doped silicon crystals. The procedure must be repeated for contacting p-type and n-type regions and the doped silicon filling has a non negligeable resistivity.

EP-A-245627 describes the formation of tungsten plugs in contact and via holes by depositing a layer of tungsten and a layer of an organic material (resist or polyimide) over the deposited tungsten layer. The organic layer is etched anisotropically without using a mask until exposing the tungsten, thus leaving residues that mask the tungsten deposited inside the contact and via holes during the successive etching of tungsten. A concavity remains over the contacts.

There is the need yet for a process for forming contact plugs of a metallic material chemically deposited from vapor phase with improved planarity conditions of the front of the wafer being fabricated.

This objective is fully met by the improved process object of the present invention.

Basically, according to the invention, a matrix blanket layer of metallic material filling the holes of contacts and of interconnection vias, chemically deposited from vapor phase, is firstly anisotropically etched back until exposing the surface of the dielectric layer through which the necessary holes for the contacts and interconnection vias had been purposely formed, as in prior art processes. At this point, through an additional masking step, for which a substantially noncritical mask, which may be "derived" easily from the mask actually employed for defining the holes of the contacts and/or of the vias through the isolation dielectric layer, may be employed, the peaks of the metal plugs, which at this point are substantially coplanar with the respectively adjacent surface of the isolation dielectric layer, are masked by "caps" of resist capable of effectively masking the peaks of the metal plugs during a successive overetching of the metallic material residues of the matrix layer which may have been left on the surface of the dielectric layer. The invention is applicable also for fabricating plugs filling contacts between different level metallizations.

The different aspects and advantages of the invention will be more easily understood through the following description and by reference to the drawings, wherein:
the Figures 1, 2, 3, the sequence of Figures 4a, 4b, 4c, and 4d and Fig. 4e schematically show the different processes for forming contacts and interconnection vias in accordance with the prior art, as already discussed;
the sequence of Figures from 5a to 5f schematically illustrates the improved process object of the present invention.

In order to facilitate cross referencing, in all the figures the same parts or equivalents thereof are indicated with the same number. Moreover, in order to avoid overburderning the figures with features of the integrated structures, which are not strictly relevant to the illustration of the specific technical problem and solutions thereof, those have been simply omitted or not described because they will surely be implicitly kept in due consideration, if necessary, by any reader skilled in the specific art.

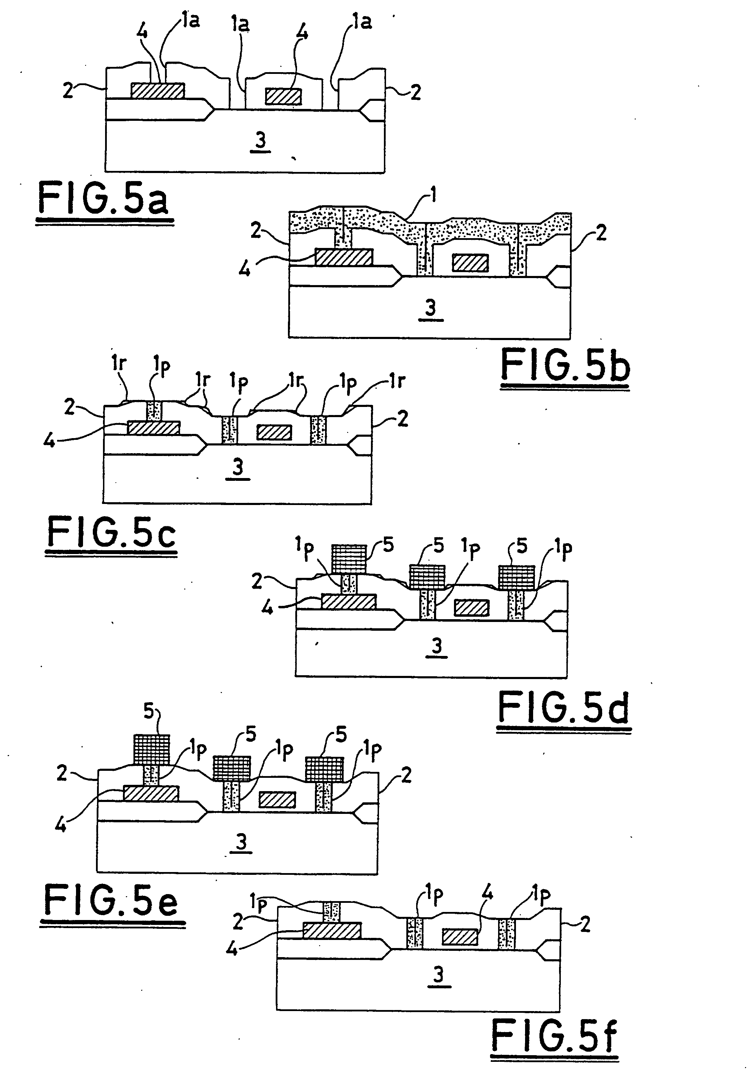

Basically, the fabrication process of integrated devices in a semiconductor wafer may follow a sequence of steps entirely conventional up to the so-called "opening of contacts" step. This latter step may normally be carried out through a lithographic definition of the contact areas utilizing an appropriate CONTACT mask, through which a layer of resist deposited on the surface of the isolation dielectric layer is exposed. Through the openings of the masking resist structure, the isolation dielectric layer is anisotropically etched, commonly in a R.I.E. plasma, until exposing the underlying surface of the layer to be contacted. The latter may be the surface of the semiconducting substrate as well as the surface of previously formed conducting layers, e.g. doped polycrystalline silicon gate lines. Customarily, techniques capable of preventing excessive damage of the contact region of the monocrystalline semiconducting substrate by ion bombardment during the etching of the overlying dielectric layer or capable of removing a superficial portion of the crystalline substrate which may have been so damaged (peeling of the contact surface) may be employed, as it is well known to a skilled technician. A typical microsection of the wafer being fabricated, at the end of these manufacturing steps, is schematically depicted in Fig. 5a, by indicating with 3 the monocrystalline semiconducting substrate, with 2 the isolation dielectric layer, with 4 the existing gate lines, commonly of doped polycrystalline silicon or of a polycrystalline silicon and refractory metal silicide double layer, and with 1a the respective holes formed through the thickness of the isolation dielectric layer 2 in order to make the relative contacts with the semiconducting substrate 3 and the relative interconnection vias with the conducting layers 4 belonging to a first level of metallization.

Subsequently, a metallic matrix layer 1, e.g. of tungsten, having a thickness sufficient to ensure a complete filling of the holes formed through the thickness of the isolation dielectric layer 2 and establishing an electric contact with the respective bottom surface of said holes, i.e. with the semiconducting substrate surface or with the surface of the conducting layer 4, as schematically shown in Fig. 5b, is deposited by chemical vapor deposition (CVD). The matrix layer 1 may be homogeneous, e.g. entirely of tungsten, or, in order to improve the adhesion characteristics and to reduce the contact resistance and prevent damages to the junctions, the matrix layer 1 may comprise a conducting pre-layer, also deposited by CVD, of a metallic material belonging to the group composed of titanium alloys, tungsten alloys, titanium, titanium alloy, titanium nitride and mixtures or multilayers of these materials alternately arranged among each other. A particularly preferred pre-layer may be constituted by a first layer of titanium onto which a second layer of titanium nitride is deposited for a total thickness of 100-150 nm. Over such a pre-layer, which may itself be multilayered, a layer of tungsten of a thickness sufficient to completely fill the contact holes may be deposited by CVD. For a 0.8 µm contact's width the matrix layer 1 may have a comprehensive total thickness comprised between 0.5 and 0.8 µm.

Whichever the real composition of the metallic matrix layer 1 deposited by CVD is, the same matrix layer must be accurately removed form the surface of the isolation dielectric layer 2. This may be effected by means of a first R.I.E. plasma anisotropic etchback step, by employing a plasma composition suitable to ensure a certain degree of etch selectivity of the metallic material of the matrix layer 1 as opposed to the dielectric material of the isolation layer 2, which is commonly an amorphous oxide (i.e. a glass). A mixture of SF₆ + O₂ may be advantageously employed for this R.I.E. etchback step of a filling layer of tungsten, until exposing the surface of the underlying isolation dielectric layer 2, in case the matrix layer 1 has been formed entirely with tungsten, or the surface of the eventual pre-layer of a metallic material different from tungsten, if such a pre-layer has been deposited before the filling layer of tungsten. In both cases, an etch-stop condition may be easily determined through analysis of the reaction products effluent from the R.I.E. reactor chamber according to common techniques well known to the skilled technician. This first etchback of the filling matrix layer of tungsten may also be conducted as described in the cited article "A STUDY OF TUNGSTEN ETCHBACK FOR CONTACT AND VIA FILL APPLICATIONS". In particular, the etchback may be carried out in several steps, for example in a mixture of SF₆ + CbrF₃ or in a mixture of SF₆ + Ar + Cl₂, as described in the article, in order to avoid undesirable lowering of the'peaks of the tungsten plugs as a consequence of the so-called loading effect which arises at the end of the etchback period upon the progressive exposure of the material underlying the tungsten. At this point, the tungsten peaks of the plugs 1p are substantially coplanar with the relatively adjacent surface of the isolation dielectric layer 2, as schematically depicted in Fig. 5c, (or with the surface of the metallic pre-layer if such has been preformed before depositing the filling layer of tungsten). In both cases, residues of tungsten are left on the surface of the underlying layer along the inevitable discontinuities from a perfect planarity of the surface, so as indicatively shown with 1r in Fig. 5c.

The etchback treatment is then interrupted at this point and as opposed to a normal sequence of steps, the wafer is subjected to an additional masking step.

For this additional masking step, a specially dedicated mask may be used, which may advantageously be derived from the CONTACT mask itself which had been employed for defining the contact areas. This derived additional mask can be easily obtained by field inversion, i.e. it may be substantially a "negative" copy of the CONTACT mask. More preferably though, during the preparation of this second mask derived from the CONTACT mask, a certain enlargement of the features is purposely produced, the "magnification" corresponding to the typical misalignment of the optical apparatus used for exposing the resist through the masks. For example for a 0.8 µm process this enlargement may indicatively be of 0.3 - 0.4 µm.

By employing this additional mask, so derived from the CONTACT mask, for exposing the resist a perfect masking of the tungsten peaks of the plugs 1p, coplanar with the surface of the dielectric layer 2 adjacent thereto (or with the surface of the pre-layer if the same exists), with caps 5 of resist is achieved, as schematically depicted in Fig. 5d.

After having so masked the peaks of tungsten of the contact plugs 1p by means of resist caps 5, an overetching of the tungsten residues 1r in a R.I.E. plasma is performed while operating with conditions similar to those of the previous etchback or, more preferably, while modifying the etching conditions so as to reduce the anisotropy of the etching and increase the selectivity toward the dielectric material (oxide) forming the isolation layer 2. To this end, it may be useful to conduct this second masked etchback of the filling tungsten for eliminating the residues thereof, in a mixture of SF₆ + Cl₂ + Ar and/or by reducing the pressure in respect to the first etchback step. This second masked etching step is carried out until a complete removal of tungsten residues 1r is achieved and may be eventually continued until complete removal also of any underlying metallic material of an eventual adhesion pre-layer is ensured. At the end of this masked overetching step of the tungsten and of the eventual adhesion metallic pre-layer, if the latter is present, the wafer presents itself substantially as depicted in Fig. 5e. Where an adhesion pre-layer constituted by a first titanium layer and a second layer of titanium nitride for a total thickness of about 100-150 nm has been formed, this multilayered pre-layer may be easily removed, after having removed all the tungsten residues, by continuing the etching in a Cl₂ plasma until a complete removal of the pre-layer material of the matrix layer.

Upon the stripping of the masking resist, the surface of the wafer being fabricated will be substantially as depicted in Fig. 5f, wherein it is evident that a complete elimination of metallic residues on the surface of the isolation dielectric layer 2 has been obtained without lowering the tungsten peaks of the preformed plugs 1p of the contacts and/or of the interconnection vias below the level of the surface of the isolation dielectric layer relatively adjacent thereto while ensuring further a perfect uniformity of the relative level of the peaks of the contacts and of the interconnection vias. The improved "coplanarity" conditions decisively improve the conditions for the subsequent deposition and definition of tracks of a highly conducting metallic material and for the further layers to be formed thereon, with positive reflexes on the yield and reliability of the process.

An adhesion pre-layer of a material different from the tungsten filling, for example, of the contacts, the second masked overetch for removing the tungsten residues 1r may also be arrested after having ensured the removal of all the tungsten residues while leaving the pre-layer material on the surface of the dielectric. The removal of this pre-layer may in this case take place at the end of a definition etching step of a subsequently deposited metallization layer which may be of aluminum or aluminum alloy or of copper or copper alloy or constituted by a multilayer of aluminum and refractory metals such as titanium and tungsten, for forming conducting tracks connecting the contact and/or via plugs over the dielectric isolation layer.

## Claims

1. A process for forming contacts with a semiconducting substrate (3) and/or interconnection vias between a first conducting layer (4) and a second conducting layer to be formed at a higher level than said first conducting layer (4), comprising forming conducting plugs (1p) of a metallic material by filling contact and/or via holes, formed through an isolation layer (2) of a dielectric material formed over said semiconducting substrate (3) and/or over said first conducting layer (4), by blanket chemical vapor deposition of a metallic matrix layer (1) comprising at least a filling layer of a metallic material chemically deposited from vapor phase, and etching back said chemically deposited matrix layer (1) for removing it from the surface of said isolation layer (2) of dielectric material while leaving said conducting plugs (1p) in the respective holes, **characterized by** the fact that the process comprises the following steps:
arresting the anisotropically etching back of said filling layer (1) of said chemically deposited metallic material when the surface of the underlying dielectric material (2) onto which said first metallic material (1) has been deposited is exposed while leaving plugs (1p) of said filling metallic material within said holes and residues (1r) along discontinuities from planarity of said surface;
masking with caps (5) of a masking material said plugs (1p);
overetching said filling metallic material (1) for eliminating said residues (1A) on the unmasked surface of said underlying dielectric material (2) under conditions of reduced anisotropy and increased etch selectivity of said filling metallic material of said matrix layer (1) versus said dielectric material of said isolation layer (2), as compared with said first etchback step.

2. The process according to claim 1, wherein the masking of said plugs is performed by depositing a layer of resist on said exposed surface, exposing the resist through a substantially field-inverted mask as compared with a mask employed for defining said holes formed through said isolation layer of dielectric material and derived from the latter mask by field inversion and enlargement of the mask profiles by a quantity equal to the typical misalignment of the exposition apparatus used for exposing the resist.

3. The process according to claim 1, wherein said chemically deposited from vapor phase metallic material is tungsten.

4. The process according to claim 3, wherein said matrix layer 1 comprises at least a prelayer, chemically deposited from vapor phase on the contact surfaces of said semiconducting substrate (3) and/or said first conducting layer (4) at the bottom of said holes, of a metallic material different from tungsten and selected from the group composed of titanium, titanium and tungsten alloy, titanium nitride and mixtures or multilayers thereof and by a filling layer of tungsten, chemically deposited from vapor phase.

5. The process according to claim 1, wherein said first etchback is performed by R.I.E. conducted in a plasma of a mixture of SF₆ and O₂.

6. The process according to claim 4, wherein said first etchback of tungsten is performed by R.I.E. conducted in a plasma of a mixture selected from the group of mixtures composed of SF₆ + CBrF₃, SF₆ + Cl₂ + Ar and SF₆ + O₂ and said overetch is performed by R.I.E. conducted in a plasma selected from the group composed of SF₆ + Cl₂ + Ar and Cl₂.

7. The process according to claim 6, wherein said overetch is continued until a complete removal of the material of said prelayer from the unmasked surface of said isolation layer (2) of dielectric material.

## Patentansprüche

1. Verfahren zur Herstellung von Kontakten mit einem halbleitenden Substrat (3) und/oder Anschluss Pfaden zwischen einer ersten stromleitenden Schicht (4) und einer zweiten stromleitenden Schicht, die auf einem höheren Niveau als der genannten ersten stromleitenden Schicht (4) herzustellen ist, umfassend die Ausbildung von stromleitenden Stopfen (1p) aus einem metallischen Werkstoff durch Füllung von Kontakt- und/oder Pfad-Bohrungen, die durch eine über das genannte Halbleiter Substrat (3) und/oder über die genannte erste stromleitende Schicht (4) gebildete isolierende Schicht (2) aus einem dielektrischen Stoff gebildet sind, mittels Blanket chemical Vapor Deposition einer metallischen mindestens eine Füllungs-Schicht aus einem chemisch aus der Dampf-Phase ausgeschiedenen metallischen Stoff umfassende Matrix-Schicht (1), und das Rückätzen der genannten chemisch ausgeschiedenen Matrix-Schicht (1) zur Entfernung derselben von der Oberfläche der genannten isolierenden Schicht (2) aus dielektrischem Stoff, wobei die genannte stromleitende Stopfen (1p) in den jeweiligen Bohrungen stehenbleiben lassen werden, **dadurch gekennzeichnet, dass** das Verfahren folgende Schritte umfasst:
beenden des anisotropischen Rückätzens der genannten Füllungs-Schicht (1) des genannten chemisch ausgeschiedenen metallischen Stoffes, wenn die Oberfläche des darrunterliegenden dielektrischen Stoffes (2) über die der genannte erste metallische Stoff (1) ausgeschieden wurde ausgesetzt ist, während Stopfen (1p) des genannten metallischen Füllungs-Stoffes in den genannten Bohrungen und Rückstände (1r) entlang Planarität Diskontinuitäten der genannten Oberfläche stehenbleiben lassen werden;
maskieren mit Kappen (5) aus einem Maskierstoff der genannten Stopfen ( 1 p);
überätzen des genannten metallischen Füllungs-Stoffes (1), damit die genannten Rückstände (1A) auf der nicht maskierten Oberfläche des genannten darunter liegenden dielektrischen Stoffes (2) entfernt werden, unter Bedingungen verminderter Anisotropie und größerer Selektivität in der Ätzung des genannten metallischen Füllungs-Stoffes der genannten Matrix-Schicht (1) gegen den genannten dielektrischen Stoff der genannten isolierenden Schicht (2) im Vergleich mit dem genannten Rückätzen Schritt.

2. Verfahren nach Anspruch 1, wobei die Maskierung des genannten Stopfens dadurch durchgeführt wird, dass eine Resist Schicht auf die genannte ausgesetzte Oberfläche aufgetragen wird, das Resist durch eine im wesentlichen feld-umgekehrte Maske im Vergleich mit einer Maske ausgesetzt wird, die zum Bestimmen der genannten durch die genannte Isolierschicht aus dielektrischem Stoff ausgebildeten Bohrungen verwendet wird und aus der letzteren Maske durch Feldumkehrung und Ausbreitung der Maskenprofile in einem gleichen Ausmaß wie die typische Missausrichtung des Aussetzungsapparats, die zur Aussetzung des Resists verwendet wird erhalten wird.

3. Verfahren nach Anspruch 1, wobei der genannte chemisch aus der Dampfphase aufgetragene metallische Stoff Wolfram ist.

4. Verfahren nach Anspruch 3, wobei die genannte Matrix-Schicht (1) mindestens eine chemisch aus der Dampfphase auf die Kontaktoberflächen des genannten Halbleitersubstrats (3) und/oder der genannten ersten stromleitenden Schicht (4) am Boden der genannten Bohrungen aufgetragene Vorschicht aus einem metallischen Stoff, der verschieden von Wolfram ist und aus der Gruppe bestehend aus Titan, Titan-Wolframlegierungen, Titannitrid und Mischungen und mehrschichtige Gebilde davon ausgewählt ist, und eine chemisch aus der Dampfphase abgeschiedene Füllungs-Schicht aus Wolfram umfasst.

5. Verfahren nach Anspruch 1, wobei das genannte erste Rückätzen durch in einem Plasma einer Mischung aus SF₆ und O₂ durchgeführtes R.I.E, erfolgt.

6. Verfahren nach Anspruch 4, wobei das genannte erste Rückätzen des Wolframs durch in einem Plasma einer Mischung, die aus der Gruppe der Mischungen bestehend aus SF₆ + CBrF₃, SF₆ + Cl₂ + Ar und SF₆ + O₂ ausgewählt ist durchgeführtes R.I.E. erfolgt, und das genannte Überätzen durch in einem Plasma einer Mischung, die aus der Gruppe der Mischungen bestehend aus SF₆ + Cl₂ + Ar und Cl₂ ausgewählt ist durchgeführtes R.I.E. erfolgt.

7. Verfahren nach Anspruch 6, wobei das genannte Überätzen bis zur vollständigen Entfernung des Stoffes der genannten Vorschicht von der unmaskierten Oberfläche der genannten isolierenden Schicht (2) aus dielektrische Stoff fortgesetzt wird.

## Revendications

1. Procédé pour la formation de contacts avec un substrat semi-conducteur (3) et/ou de voies d'interconnexion entre une première couche conductrice (4) et une deuxième couche conductrice qui doit être formée à un niveau supérieur à la première couche conductrice (4), comprenant la formation d'un bouchon conducteur (1p) en un matériau métallique par remplissage des trous de contact ou de voie, formés à travers d'une couche d'isolation (2) d'un matériau diélectrique formé sur ledit substrat semi-conducteur (3) et/ou sur ladite première couche conductrice (4), par dépôt chimique depuis phase de vapeur d'une couche métallique de matrice (1) comprenant au moins une couche de remplissage d'un matériau métallique déposé chimiquement de la phase de vapeur, et nouveau attaque de ladite couche de matrice (1) déposée chimiquement afin de son déplacement de la surface de ladite couche d'isolation (2) d'un matériau diélectrique, en laissant en même temps lesdits bouchons conducteurs (1p) dans leurs respectifs trous, **caractérisé en ce que** le procédé comprend les étapes suivantes:
interruption de l'attaque anisotropique de ladite couche de remplissage (1) dudit matériau métallique déposé chimiquement quand la surface du matériau diélectrique (2) sous-jacent sur lequel ledit premier matériau métallique (1) a été déposé est exposée, en laissant en même temps des bouchons (1p) dudit matériau métallique de remplissage à l'intérieur desdits trous, et des résidus (lr) lelong de discontinuités de la planéité de ladite surface;
masquage avec des capuchons (5) d'un matériau de masquage desdits bouchons (1p);
sur-attaque dudit matériau métallique (1) de remplissage pou éliminer les dits résidus (1A) sur la surface non masquée dudit matériau diélectrique (2) sous-jacent dans des conditions d'anisotropie réduite et de sélectivité d'attaque augmentée pour ledit matériau métallique de remplissage de ladite couche de matrice (1) en comparaison avec ledit matériau diélectrique de ladite couche d'isolation (2), par rapport à ladite première phase de nouveau attaque.

2. Procédé selon la revendication 1, dans lequel le masquage dudit bouchon est obtenu par dépôt d'une couche de resist sur ladite surface exposée, exposition du resist à travers d'un masque substantiellement à champ inverti par rapport à un masque employé pour définir lesdits trous formés à travers de ladite couche d'isolation en matériau diélectrique et dérivé du dernier masque par inversion de champ et élargissement des profils de masquage dans une mesure correspondante au mal-alignement typique de l'appareil d'exposition utilisé pour exposer le resist.

3. Procédé selon la revendication 1, dans lequel ledit matériau métallique déposé chimiquement de la phase de vapeur est du tungstène.

4. Procédé selon la revendication 3, dans lequel ladite couche de matrice (1) comprend au moins une pre-couche, déposée par voie chimique de la phase de vapeur sur les surfaces de contact dudit substrat semi-conducteur (3) et/ou ladite première couche conductrice (4) au fond desdits trous, d'un matériau métallique différent du tungstène et choisi dans le group composé par le titane, les alliages de titane et tungstène, le nitrure de titane et mélanges ou multicouches des mêmes te par une couche de remplissage de tungstène chimiquement déposée de la phase de vapeur.

5. Procédé selon la revendication 1, dans lequel ledit premier re-attaque est obtenu par R.I.E. conduit dans un plasma d'un mélange de SF₆ et O₂.

6. Procédé selon la revendication 4, dans lequel ledit premier re-attaque du tungstène est obtenu par R.I.E. conduit dans un plasma d'un mélange choisi dans le group des mélanges composés par SF₆ + CBrF₃, SF₆ + Cl₂ + Ar et SF₆ + O₂ et ledit re-attaque est obtenu par R.I.E. conduit dans un plasma choisi dans le group composé par SF₆ + Cl₂ + Ar et Cl₂.

7. Procédé selon la revendication 6, dans lequel ledit re-attaque est continué jusqu'à l'enlèvement complet de ladite pre-couche de la surface non masquée de ladite couche isolante (2) en matériau diélectrique.
